# EUROPÄISCHE PATENTSCHRIFT

(11) **EP 1 384 323 B1**
(45) Veröffentlichungstag und Bekanntmachung des Hinweises auf die Patenterteilung: **30.07.2008**
(21) Anmeldenummer: 02745261.4
(22) Anmeldetag: 24.04.2002
(51) Int. Cl.: H03H 11/04

(54) **VERFAHREN UND VORRICHTUNG ZUM EINSTELLEN EINES AKTIVEN FILTERS**
METHOD AND DEVICE FOR ADJUSTING AN ACTIVE FILTER
PROCEDE ET DISPOSITIF DE REGLAGE D'UN FILTRE ACTIF

(30) Priorität: 03.05.2001 DE 10121517
(43) Veröffentlichungstag der Anmeldung: 28.01.2004
(73) Patentinhaber: Infineon Technologies AG, 81669 München (DE)
(72) Erfinder: FLEISCHHACKER, Christian, A-9064 Pischeldorf (AT); LABATE, Francesco, A-9500 Villach (AT); WEINBERGER, Hubert, A-8540 Soboth (AT); KODER, Günter, A-9162 Strau (AT); STABER, Michael, A-9500 Villach (AT)
(74) Vertreter: Banzer, Hans-Jörg
(86) Internationale Anmeldenummer: PCT/EP2002/004528
(87) Internationale Veröffentlichungsnummer: WO 2002/091573

(56) Entgegenhaltungen:
- EP-A- 0 421 423
- US-A- 4 733 205

## Beschreibung

Die vorliegende Erfindung betrifft ein Verfahren bzw. eine Schaltungsanordnung zum Einstellen eines aktiven Filters nach dem Oberbegriff des Anspruchs 1 bzw. des Anspruchs 5.

Aktive Filter werden beispielsweise in Telekommunikationsnetzen eingesetzt. Dabei werden aktive Filter insbesondere bei digitalen Übertragungsverfahren als Vor- bzw. Nachfilter vor einem Analog-Digitalumsetzer bzw. nach einem Digital-Analogumsetzer eingesetzt. Bei einer solchen Anwendung in der Digitaltechnik ist die Einhaltung eines bestimmten Sollfrequenzgangs abhängig von den im Digitalsystem verwendeten Taktfrequenzen extrem wichtig. Werden als frequenzgangbestimmende Elemente eines aktiven Filters unter anderem Kapazitäten verwendet, die bei der Fertigung nachteiligerweise sehr starke Streuungen aufweisen, ist in der Regel eine Abgleichmöglichkeit zum Einstellen des Frequenzgangs erforderlich. In der Regel werden solche aktive Filter zur Verwendung in Telekommunikationsnetzen zusammen mit einer Abgleichschaltung in einem Halbleiter integriert.

Beispielsweise wird in VDSL-Systemen ein aktives Tiefpassfilter benötigt, dessen Eckfrequenz auf eine von mehreren Frequenzen zwischen 8 und 12,44 MHz einstellbar sein muss, wobei die zulässige Toleranz ± 5% des Frequenzwerts beträgt. Wird nun für jede einstellbare Sollfrequenz ein Satz von frequenzgangbestimmenden Kapazitäten zusammen mit der jeweils erforderlichen Abgleichschaltung eingesetzt, ergibt sich nachteiligerweise ein sehr hoher Schaltungsaufwand, der aufgrund des Umfangs weitere Nachteile, wie beispielsweise parasitäre Kapazitäten, mit sich bringt.

Aus der EP 0 421 423 A2 ist ein Verfahren bzw. eine Schaltungsanordnung zum Einstellen eines aktiven Filters nach dem Oberbegriff des Anspruchs 1 bzw. des Anspruchs 5 bekannt. Dabei wird zum Einstellen des aktiven Filters ein Maß für den Frequenzgang des Filters bestimmt, um abhängig von dem bestimmten Maß für den Frequenzgang des Filters eine Vielzahl von zur Verfügung stehenden Kapazitäten über steuerbare Schalter zu schalten.

Eine ähnliche Schaltungsanordnung bzw. ein ähnliches Verfahren ist aus der US 4,733,205 A bekannt, wobei über ein Bitregister die zu schaltenden Kapazitäten angesteuert werden.

Aus den Druckschriften WO 00/41045 A1, US 5,532,922 A und WO 00/08870 A1 sind jeweils die Generierung und der Gebrauch von Look-Up-Tabellen in Regelungssystemen bekannt.

Der vorliegenden Erfindung liegt die Aufgabe zugrunde, eine Schaltungsanordnung und ein Verfahren zum Einstellen eines aktiven Filters der eingangs genannten Art zu schaffen, mit denen bei geringem Schaltungsaufwand ein Frequenzgang von mehreren mit hoher Genauigkeit eingestellt werden kann.

Diese Aufgabe wird erfindungsgemäß durch ein Verfahren mit den Merkmalen des Anspruchs 1 sowie eine Schaltungsanordnung mit den Merkmalen des Anspruchs 5 gelöst. Die Unteransprüche definieren jeweils bevorzugte und vorteilhafte Ausführungsformen der vorliegenden Erfindung.

Bei dem erfindungsgemäßen Verfahren wird eine Speicheranordnung verwendet, in der Regeln zum Verändern der einstellbaren, frequenzgangbestimmenden Kapazität enthalten sind, wobei bei der Auswahl der Regel die beabsichtigte Solleckfrequenz bzw. der Sollfrequenzgang als auch ein Maß für den Istfrequenzgang des aktiven Filters berücksichtigt wird. Die Einstellung ist vorteilhafterweise in einem Arbeitsgang möglich, so dass nicht zunächst der Sollfrequenzgang eingestellt und danach in einem weiteren Schritt abgeglichen werden muss.

Zum Ermitteln des Maßes für den Frequenzgang des Filters wird eine Referenzkapazität herangezogen, deren Wert in einem bekannten Verhältnis zum Wert der frequenzgangbestimmenden Kapazitäten des Filters steht. In diesem Fall kann ein Maß für den Wert der Referenzkapazität ermittelt werden und von diesem Wert auf den Wert der Kapazität im Filter bzw. auf den Frequenzgang des Filters geschlossen werden. Auf diese Weise muss an das Filter keine Schaltung zum Bestimmen des Frequenzgangmaßes angeschlossen werden, die die Funktion des Filters beispielsweise in Folge von parasitären Kapazitäten oder der Übergangswiderstände von eingefügten Schaltern beeinträchtigen könnte.

Das Heranziehen einer Referenzkapazität bietet sich insbesondere bei einer Integration zumindest aller Kapazitäten auf einem Chip bzw. Halbleiter an, bei der die Absolutwerte der Kapazitäten schwanken können, jedoch das Verhältnis der Werte der verschiedenen Kapazitäten zueinander gut reproduzierbar und genau bestimmbar bzw. bekannt ist. Dabei kann insbesondere vorgesehen werden, dass sämtliche Kapazitäten aus Einheitskapazitäten gleichen Werts durch Parallel- oder Serienschaltung wenigstens einer Einheitskapazität gebildet werden. Das Verhältnis insbesondere der Referenzkapazität zu einer anderen Kapazität ist in so einem Fall durch die Anzahl und Art der Kombination der jeweils verschalteten Einheitskapazitäten bestimmt.

Als Maß für den Frequenzgang wird vorteilhafterweise eine Zeitkonstante bestimmt, die sich besonders einfach durch eine Zeitmessung ermitteln lässt. Dazu kann beispielsweise ein Sprungsignal auf den Eingang des Filters bzw. auf die Referenzkapazität geschaltet werden und die Zeitdauer gemessen werden, bis das Ausgangssignal des Filters bzw. eine Spannung an der Referenzkapazität einen bestimmten Wert erreicht.

Durch das Normieren der Zeitkonstante auf eine bestimmte Messfrequenz kann die Messung des Istfrequenzgangs bei beliebigen Frequenzen unabhängig von der Solleckfrequenz durchgeführt werden.

Wird als Speicheranordnung ein adressierbarer Tabellenspeicher verwendet, kann die Auswahl der Einstellregel für die einstellbare Kapazität besonders einfach erfolgen, indem ein mehrstelliger Adressbereich des Tabellenspeichers aufgeteilt wird und ein Teil von der Auswahl der Solleckfrequenz adressiert und der andere Teil von dem Maß des Istfrequenzgangs adressiert wird. Beispielsweise können bei einem Adressbereich mit 10 Bit 3 Bit zur Auswahl einer bestimmten Sollfilterfrequenz verwendet werden, wobei insgesamt 8 Sollfilterfrequenzen auswählbar wären, und die restlichen 7 Bit zur Eingabe des Maßes für den Istfrequenzgang verwendet werden.

Die in der Speicheranordnung hinterlegten Einstellregeln müssen dabei eine Einstellung der frequenzgangbestimmenden Kapazität mit einer so hohen Genauigkeit ermöglichen, dass sich der gewünschte Sollfrequenzgang und der Abgleich realisieren lässt.

Vorteilhafterweise weist die einstellbare Kapazität mehrere parallel geschaltete Serienschaltungen mit jeweils einer Einzelkapazität und einem Schalter auf. Die Gesamtkapazität dieser Schaltungsanordnung ergibt sich aus der Summe der in Reihe mit geschlossenen Schaltern liegenden Einzelkapazitäten. Dabei kann vorgesehen sein, dass sich die Werte der Einzelkapazitäten zueinander wie ganzzahlige Zweierpotenzen verhalten. In diesem Fall kann vorteilhafterweise ein als Einstellregel hinterlegtes Binärwort direkt zum Schließen der Schalter bzw. zum Einstellen der Kapazität verwendet werden. Die einstellbare Kapazität kann weiterhin eine Basiskapazität aufweisen, der eine Schaltungsanordnung variabler Kapazität parallel geschaltet ist, so dass der Einstellbereich der einstellbaren Kapazität geringer sein kann.

Bei der Einstellung der Kapazität kann vorgesehen sein, die Messung des Istfrequenzgangs und nachfolgende Auswahl einer Einstellregel mehrfach durchzuführen, um insbesondere in den Fällen zu einer höheren Genauigkeit zu gelangen, in denen die Auswirkung einer Einstellhandlung bei der einstellbaren Kapazität nicht vorherbestimmbar ist. Dies kann beispielsweise im Fall von parallel geschalteten und einzeln zuschaltbaren Einzelkapazitäten infolge von Fertigungstoleranzen der Einzelkapazitäten der Fall sein. Sollte in so einem Fall die zugeschaltete Einzelkapazität einen anderen Wert aufweisen, als der Einstellregel zugrunde gelegt worden ist, kann dies in einer zweiten Messung ermittelt werden und die Einstellung erneut vorgenommen werden.

Wird das aktive Filter zusammen mit sämtlichen zur Durchführung des erfindungsgemäßen Verfahrens nötigen Komponenten in einem Halbleiter integriert, so können die Kosten dafür verringert werden, insbesondere wenn die erfindungsgemäße Schaltungsanordnung beispielsweise bei einem Einsatz in einem Telekommunikationsnetz in sehr hohen Stückzahlen benötigt wird.

Die Erfindung wird nachfolgend anhand eines bevorzugten Ausführungsbeispiels unter Bezugnahme auf die beigefügte Zeichnung näher erläutert.

Figur 1 zeigt den Aufbau eines aktiven Filters mit den frequenzgangbestimmenden Komponenten, und

Figur 2 zeigt ein Blockschaltbild des aktiven Filters zusammen mit den zur Einstellung erforderlichen Komponenten.

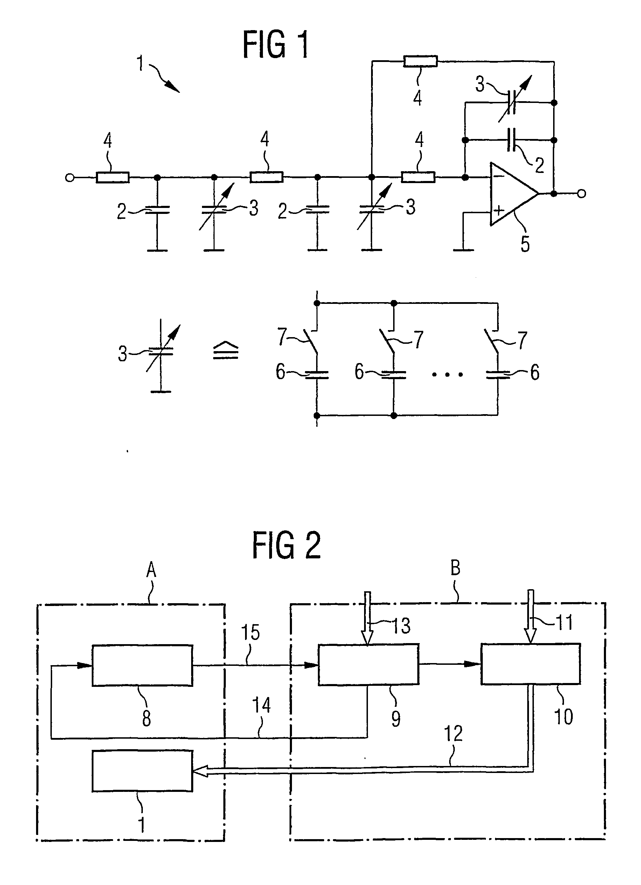

In Figur 1 ist als aktives Filter 1 ein Tschebyscheff-Tiefpassfilter dritter Ordnung dargestellt. Das Filter 1 weist dazu einen Operationsverstärker 5 und zur äußeren Beschaltung Widerstände 4 und Kapazitäten 2, 3 auf, die den Frequenzgang des Filters 1 bestimmen. Die Kapazitäten 2 sind jeweils Festkapazitäten, wohingegen die Kapazitäten 3 einstellbar sind.

Die einstellbaren Kapazitäten 3 bestehen jeweils aus einer Parallelschaltung von Einzelkapazitäten 6, die in Serie mit Schaltern 7 geschaltet sind, wobei die Einzelkapazitäten 6 einer einstellbaren Kapazität 3 unterschiedliche Werte aufweisen, die sich zueinander so verhalten wie ganzzahlige Zweierpotenzen.

Der Wert der Basiskapazität 2 ist so bemessen, dass bei Einstellung der einstellbaren Kapazität 3 auf den kleinstmöglichen Wert, d.h. bei Öffnung aller Schalter 7, eine Eckfrequenz des Filters 1 erreicht wird, die bei Berücksichtigung üblicher Fertigungstoleranzen oberhalb der höchsten einzustellenden Eckfrequenz liegt.

Das in Figur 1 dargestellte Filter 1 ist zur Verwendung in einem VDSL-System vorgesehen und soll dort als Vor- bzw. Nachfilter vor einem Analog-Digital-Umsetzer bzw. nach einem Digital-Analog-Umsetzer eingesetzt werden.

Figur 2 zeigt ein Blockschaltbild des aktiven Filters 1 zusammen mit den zum Durchführen des Verfahrens notwendigen Komponenten. Die Komponenten sind in einen Analogteil A und einen Digitalteil B gegliedert. Der Analogteil A weist das aktive Filter 1 zusammen mit einer Einrichtung 8 zur Bestimmung eines Maßes des Frequenzgangs des Filters 1 auf. Der Digitalteil B weist eine Steuereinrichtung 9 und eine Speichereinrichtung 10 auf. Die Steuereinrichtung 9 erhält über einen Takteingang 13 ein Taktsignal. Weiterhin ist die Steuereinrichtung 9 über eine Startleitung 14 und eine Stoppleitung 15 mit der Messeinrichtung 8 verbunden, mittels derer sie die Messung des Istfrequenzgangs anstoßen und eine Rückmeldung des ermittelten Maßes für den Istfrequenzgang empfangen kann.

Als Maß für den Frequenzgang des Filters 1 wird eine Zeitkonstante ermittelt. Dazu sendet die Steuereinrichtung 9 ein Signal über die Startleitung 14 an die Messeinrichtung 8, die daraufhin die Messung startet, indem sie an den Eingang des Filters 1 ein Sprungsignal anlegt. Gleichzeitig startet die Steuereinrichtung 9 einen Zähler, der im Takt der über die Leitung 13 angelegten Frequenz nach oben zählt.

Von der Messeinrichtung 8 wird währenddessen der Ausgang des Filters 1 auf das Erreichen eines bestimmten Spannungswerts hin überwacht. Sobald dieser Wert erreicht ist, sendet die Messeinrichtung 8 über die Stoppleitung 15 ein Signal an die Steuereinrichtung 9, die daraufhin den Zähler stoppt und den erreichten Zählwert auf die Frequenz des angelegten Taktsignals normiert. Dieser normierte Zählwert entspricht dann einer Zeitkonstante, die über eine Leitung der Speicheranordnung 10 zugeführt wird.

Gleichzeitig wird der Speicheranordnung 10 über eine Eingangsleitung 11 mitgeteilt, welche Solleckfrequenz eingestellt werden soll. Die an der Speicheranordnung 10 anliegenden Informationen über die einzustellende Solleckfrequenz und die normierte Zeitkonstante werden in der Speicheranordnung 10 zu einem mehrstelligen Adresssignal für einen Tabellenspeicher verknüpft. In diesem Tabellenspeicher ist für jede Kombination jeder einstellbaren Sollfilterfrequenz und den möglichen Werten der ermittelten digitalen Zeitkonstante eine Einstellregel zum Einstellen der Kapazitäten 3 hinterlegt. Sollen beispielsweise sechs verschiedene Filterfrequenzen einstellbar sein und liegt der Digitalwert der normierten Zeitkonstante in einem Bereich von 0 bis 999, so müssen 6000 verschiedene Einstellregeln in der Speicheranordnung 10 hinterlegt sein. Die Speicheranordnung wird also als Look-up-Table für die Einstellregeln verwendet.

Dabei kann der Aufwand für die Verknüpfung der ermittelten Zeitkonstante und die Information über die Solleckfrequenz zur Auswahl der Einstellregel vereinfacht werden, indem die Information über die Sollfilterfrequenz und die ermittelte Zeitkonstante jeweils in Form eines binären Digitalwerts an die Steuereinrichtung 10 übertragen wird, und dort auf verschiedene Leitungen eines mehrere Bit breiten Adresseingangs geschaltet wird. Auf diese Weise ist keine aufwendige Logik erforderlich und für die Speichereinrichtung 10 kann ein üblicher Nur-Lesespeicher verwendet werden. Da solche Speicher in aller Regel nur mit einer bestimmten Anzahl an Speicherzellen verfügbar sind, bleiben unter Umständen Speicherzellen ungenutzt, wenn die Anzahl der Kombinationen aus der Anzahl der Sollfilterfrequenzen und der möglichen Zeitkonstanten kleiner als die Anzahl der Speicherzellen ist.

Weiterhin ist es jedoch auch möglich, für die Speicherung der Einstellregeln einen anderen Tabellenspeicher zu nutzen, der beispielsweise als Programmspeicher für einen Mikrokontroller oder einen Prozessor dient. Dort können die Einstellregeln in einem ungenutzten Speicherbereich, beginnend mit einer bestimmten Startadresse hinterlegt werden. Der sich aus der Kombination der Zeitkonstante und der Information über die Sollfilterfrequenz ergebende Adresswert wäre in so einem Fall als Offset zu interpretieren, der zu der Startadresse hinzu addiert werden muss. Diese Möglichkeit bietet sich insbesondere in den Fällen an, in denen die erfindungsgemäße Schaltungsanordnung in einem Halbleiter integriert ist, in dem ohnehin ein programmgesteuertes Steuerwerk mit einem Tabellenspeicher vorhanden ist.

## Patentansprüche

1. Verfahren zum Einstellen eines aktiven Filters (1) mit einer frequenzgangbestimmenden Kapazität (2, 3), bei dem ein Maß für den Frequenzgang des Filters (1) bestimmt wird,
**dadurch gekennzeichnet,**
**dass** als das Maß für den Frequenzgang des Filters (1) ein Maß für den Wert einer Referenzkapazität, deren Wert in einem bekannten Verhältnis zum Wert der frequenzgangbestimmenden Kapazität (2, 3) steht, ermittelt wird, und
**dass** abhängig von dem ermittelten Maß für den Frequenzgang und einem vorgebbaren Sollfrequenzgang aus einer Speicheranordnung (10) eine Einstellregel aus einer Mehrzahl von in der Speicheranordnung (10) abgespeicherten Einstellregeln ausgewählt wird und die einstellbare Kapazität (2, 3) entsprechend der ausgewählten Einstellregel eingestellt wird.

2. Verfahren nach Anspruch 1,
**dadurch gekennzeichnet,**
**dass** als Maß für den Frequenzgang des Filters (1) eine Zeitkonstante ermittelt wird.

3. Verfahren nach Anspruch 2,
**dadurch gekennzeichnet,**
**dass** die ermittelte Zeitkonstante auf einen bestimmten Wert einer bei der Ermittlung der Zeitkonstante verwendeten Taktfrequenz normiert wird.

4. Verfahren nach einem der Ansprüche 1 bis 3,
**dadurch gekennzeichnet,**
**dass** als Speicheranordnung ein adressierbarer Tabellenspeicher (10) verwendet wird, dessen Adresse eine Wortbreite mit wenigstens zwei Stellen aufweist, und wenigstens eine Stelle der Adresswortbreite mit einem vom ermittelten Maß für den Frequenzgang abgeleiteten Digitalwert und wenigstens eine Stelle der Adresswortbreite mit einem den vorgegebenen Sollfrequenzgang beschreibenden Digitalwert beaufschlagt wird.

5. Schaltungsanordnung zur Filterung eines elektrischen Signals mit einem aktiven Filter (1) mit wenigstens einer frequenzgangbestimmenden einstellbaren Kapazität (2, 3), mit einem Schaltkreis (8) zur Bestimmung eines Maßes für den Frequenzgang des Filters (1),
**gekennzeichnet durch** eine Speicheranordnung (10), in der eine Mehrzahl von Einstellregeln zum Einstellen der einstellbaren Kapazität (2, 3) hinterlegbar ist und eine derart eingerichteten Steuereinrichtung (9), dass sie abhängig vom ermittelten Maß für den Frequenzgang und einem an der Schaltungsanordnung eingestellten Sollfrequenzgang eine hinterlegte Einstellregel auswählt und die einstellbare Kapazität (2, 3) entsprechend der ausgewählten Einstellregel einstellt,
wobei die Schaltungsanordnung wenigstens eine Referenzkapazität aufweist, deren Wert in einem bekannten Verhältnis zum Wert wenigstens einer frequenzgangbestimmenden Kapazität (2, 3) steht, der Schaltkreis (8) zur Bestimmung eines Maßes für Frequenzgang des Filters (1) derart eingerichtet ist, dass er ein Maß für den Wert der Referenzkapazität ermittelt, und die Steuereinrichtung (9) derart eingerichtet ist, dass sie anstelle des Maßes für den Frequenzgang des Filters (1) das Maß für den Wert der Referenzkapazität verwendet.

6. Schaltungsanordnung nach Anspruch 5,
**dadurch gekennzeichnet,**
**dass** die einstellbare Kapazität (2, 3) wenigstens eine nicht veränderbare Basiskapazität (2) und eine einstellbare Teilkapazität (3) aufweist.

7. Schaltungsanordnung nach Anspruch 5 oder 6,
**dadurch gekennzeichnet,**
**dass** die einstellbare Kapazität (2, 3) mehrere parallel geschaltete Serienschaltungen bestehend aus jeweils einer Einzelkapazität (6) und einem Schalter (7) aufweist.

8. Schaltungsanordnung nach einem der Ansprüche 5 bis 7,
**dadurch gekennzeichnet,**
**dass** die Speicheranordnung einen Tabellenspeicher (10) aufweist, in dem als Einstellregeln Digitalwerte binär speicherbar sind.

9. Schaltungsanordnung nach Anspruch 8,
**dadurch gekennzeichnet,**
**dass** der Tabellenspeicher (10) eine Adresswortbreite mit wenigstens zwei Stellen aufweist und die Schaltungsanordnung derart eingerichtet ist, dass sie wenigstens eine Stelle der Adresswortbreite mit einem vom ermittelten Maß für den Frequenzgang abgeleiteten Digitalwert und wenigstens eine Stelle der Adresswortbreite mit einem den vorgegebenen Sollfrequenzgang beschreibenden Digitalwert beaufschlagt.

10. Schaltungsanordnung nach einem der Ansprüche 5 bis 9,
**dadurch gekennzeichnet,**
**dass** die Schaltungsanordnung derart eingerichtet ist, dass sie als Maß für den Frequenzgang eine Zeitkonstante bestimmt.

11. Schaltungsanordnung nach Anspruch 10,
**dadurch gekennzeichnet,**
**dass** die Schaltungsanordnung derart eingerichtet ist, dass sie die ermittelte Zeitkonstante auf einen bestimmten Wert einer bei der Ermittlung der Zeitkonstante verwendeten Taktfrequenz normiert.

12. Schaltungsanordnung nach einem der Ansprüche 5 bis 11,
**dadurch gekennzeichnet,**
**dass** die Komponenten der Schaltungsanordnung in einem Halbleiter integriert sind.

13. Schaltungsanordnung nach einem der Ansprüche 5 bis 12,
**dadurch gekennzeichnet,**
**dass** die Referenzkapazität und die frequenzgangbestimmende Kapazität aus Einheitskapazitäten gleichen Werts aufgebaut sind.

## Claims

1. Method for adjusting an active filter (1) with a capacitor (2, 3) which determines frequency response, which involves determining a measure of the frequency response of the filter (1),
**characterized**
**in that** the measure of the frequency response of the filter (1) which is ascertained is a measure of the value of a reference capacitor whose value is in a known ratio to the value of the capacitor (2, 3) which determines frequency response, and
**in that** the ascertained measure of the frequency response and a prescribable nominal frequency response from a memory arrangement (10) are taken as a basis for selecting an adjustment rule from a plurality of adjustment rules stored in the memory arrangement (10), and the adjustable capacitor (2, 3) is adjusted on the basis of the selected adjustment rule.

2. Method according to Claim 1,
**characterized**
**in that** a time constant is ascertained as a measure of the frequency response of the filter (1).

3. Method according to Claim 2,
**characterized**
**in that** the ascertained time constant is normalized to a particular value of a clock frequency used when ascertaining the time constant.

4. Method according to one of Claims 1 to 3,
**characterized**
**in that** the memory arrangement used is an addressable table memory (10) whose address has a word length comprising at least two digits, and at least one digit in the address word length is filled with a digital value derived from the ascertained measure of the frequency response, and at least one digit in the address word length is filled with a digital value which describes the prescribed nominal frequency response.

5. Circuit arrangement for filtering an electrical signal with an active filter (1) with at least one adjustable capacitor (2, 3) which determines frequency response, with a circuit (8) for determining a measure of the frequency response of the filter (1),
**Characterized by** a memory arrangement (10), which can store a plurality of adjustment rules for adjusting the adjustable capacitor (2, 3), and a control device (9) which is set up such that it takes the ascertained measure of the frequency response and a nominal frequency response which has been set on the circuit arrangement as a basis for selecting a stored adjustment rule and adjusts the adjustable capacitor (2, 3) on the basis of the selected adjustment rule, the circuit arrangement having at least one reference capacitor whose value is in a known ratio to the value of at least one capacitor (2, 3) which determines frequency response, the circuit (8) for determining a measure of the frequency response of the filter (1) being set up such that it ascertains a measure of the value of the reference capacitor, and the control device (9) being set up such that it uses the measure of the value of the reference capacitor instead of the measure of the frequency response of the filter (1).

6. Circuit arrangement according to Claim 5,
**characterized**
**in that** the adjustable capacitor (2, 3) has at least one invariable base capacitor (2) and an adjustable capacitor component (3).

7. Circuit arrangement according to Claim 5 or 6,
**characterized**
**in that** the adjustable capacitor (2, 3) has a plurality of series circuits connected in parallel which each comprise a single capacitor (6) and a switch (7).

8. Circuit arrangement according to one of Claims 5 to 7,
**characterized**
**in that** the memory arrangement has a table memory (10) which can store digital values in binary form as adjustment rules.

9. Circuit arrangement according to Claim 8,
**characterized**
**in that** the table memory (10) has an address word length comprising at least two digits, and the circuit arrangement is such that it fills at least one digit in the address word length with a digital value derived from the ascertained measure of the frequency response and fills at least one digit in the address word length with a digital value which describes the prescribed nominal frequency response.

10. Circuit arrangement according to one of Claims 5 to 9,
**characterized**
**in that** the circuit arrangement is set up such that it determines a time constant as a measure of the frequency response.

11. Circuit arrangement according to Claim 10,
**characterized**
**in that** the circuit arrangement is set up such that it normalizes the ascertained time constant to a particular value of a clock frequency used when ascertaining the time constant.

12. Circuit arrangement according to one of Claims 5 to 11,
**characterized**
**in that** the components of the circuit arrangement are integrated in a semiconductor.

13. Circuit arrangement according to one of Claims 5 to 12,
**characterized**
**in that** the reference capacitor and the capacitor which determines frequency response are made up of standard capacitors of the same value.

## Revendications

1. Procédé de réglage d'un filtre ( 1 ) actif ayant une capacité ( 2, 3 ) déterminant la réponse fréquentielle, dans lequel on détermine une mesure de la réponse fréquentielle du filtre ( 1 ),
**caractérisé**
**en ce que** l'on détermine comme mesure de la réponse fréquentielle du filtre ( 1 ) une mesure de la valeur d'une capacité de référence dont la valeur est dans un rapport connu à la valeur de la capacité ( 2, 3 ) déterminant la réponse fréquentielle, et
**en ce qu'**en fonction de la mesure déterminée de la réponse fréquentielle et d'une réponse fréquentielle de consigne pouvant être prescrite à partir d'un dispositif ( 10 ) de mémoire, on choisit une règle de réglage dans une multiplicité de règles de réglage mémorisées dans le dispositif ( 10 ) de mémoire et l'on règle la capacité ( 2, 3 ) réglable conformément à la règle de réglage choisie.

2. Procédé suivant la revendication 1,
**caractérisé**
**en ce que** l'on détermine une constante de temps comme mesure de la réponse fréquentielle du filtre ( 1 ).

3. Procédé suivant la revendication 2,
**caractérisé**
**en ce que** l'on norme la constante de temps déterminée sur une valeur déterminée d'une fréquence d'horloge utilisée lors de la détermination de la constante de temps.

4. Procédé suivant l'une des revendications 1 à 3,
**caractérisé**
**en ce que** l'on utilise, comme dispositif de mémoire, une mémoire ( 1 ) à table pouvant être adressée, dont l'adresse comporte une largeur de mot ayant au moins deux positions, et au moins une position de la largeur du mot d'adresse est chargée de la valeur numérique dérivée de la mesure déterminée pour la réponse fréquentielle et au moins une position de la largeur du mot d'adresse est chargée d'une valeur numérique décrivant la réponse fréquentielle de consigne prescrite.

5. Montage de filtrage d'un signal électrique comprenant un filtre ( 1 ) actif ayant au moins une capacité ( 2, 3 ) réglable déterminant la réponse fréquentielle, un circuit ( 8 ) de détermination d'une mesure de la réponse fréquentielle du filtre ( 1 ),
**caractérisé par** un dispositif ( 10 ) de mémoire dans lequel peuvent être mémorisés une multiplicité de règles de réglage pour réguler la capacité ( 2, 3 ) réglable et un dispositif ( 9 ) de commande tel qu'il choisit, en fonction de la mesure déterminée de la réponse fréquentielle et d'une réponse fréquentielle de consigne mise dans le montage, une règle de réglage mémorisée et règle la capacité ( 2, 3 ) réglable en fonction de la règle de réglage choisie,
le montage ayant au moins une capacité de référence dont la valeur est dans un rapport connu à la valeur d'au moins une capacité ( 2, 3 ) déterminant la réponse fréquentielle, le circuit ( 8 ) de détermination d'une mesure de la réponse fréquentielle du filtre ( 1 ) étant tel qu'il détermine une mesure de la valeur de la capacité de référence, et le dispositif ( 9 ) de commande étant tel qu'il utilise, au lieu de la mesure de la réponse fréquentielle du filtre ( 1 ), la mesure de la valeur de la capacité de référence.

6. Montage suivant la revendication 5,
**caractérisé**
**en ce que** la capacité ( 2, 3 ) réglable a au moins une capacité ( 2 ) de base qui ne peut pas être modifiée et une sous-capacité ( 3 ) qui peut être réglée.

7. Montage suivant la revendication 5 ou 6,
**caractérisé**
**en ce que** la capacité ( 2, 3 ) réglable a plusieurs circuits séries montés en parallèle, constitués respectivement d'une capacité ( 6 ) individuelle et d'un interrupteur ( 7 ).

8. Montage suivant l'une des revendications 5 à 7,
**caractérisé**
**en ce que** le dispositif de mémoire a une mémoire ( 10 ) à table dans laquelle peuvent être mémorisées de façon binaire des valeurs numériques en tant que règle de réglage.

9. Montage suivant la revendication 8,
**caractérisé**
**en ce que** la mémoire ( 10 ) à table a une largeur de mot d'adresse ayant au moins deux positions et le montage est tel qu'il charge au moins une position de la largeur du mot d'adresse d'une valeur numérique dérivée de la valeur déterminée de la réponse fréquentielle et au moins une position de la largeur du mot d'adresse d'une valeur numérique décrivant la réponse fréquentielle de consigne prescrite.

10. Montage suivant l'une des revendications 5 à 9,
**caractérisé**
**en ce que** le montage est tel qu'il détermine une constante de temps comme mesure de la réponse fréquentielle.

11. Montage suivant la revendication 10,
**caractérisé**
**en ce que** le montage est tel qu'il norme la constante de temps déterminée sur une valeur déterminée d'une fréquence d'horloge utilisée dans la détermination de la constante de temps.

12. Montage suivant l'une des revendications 5 à 11,
**caractérisé**
**en ce que** les composants du montage sont intégrés dans un semi-conducteur.

13. Montage suivant l'une des revendications 5 à 12,
**caractérisé**
**en ce que** la capacité de référence et la capacité déterminant la réponse fréquentielle sont constituées de capacités individuelles de même valeur.
